# EUROPÄISCHE PATENTSCHRIFT

(11) **EP 1 206 904 B1**
(45) Veröffentlichungstag und Bekanntmachung des Hinweises auf die Patenterteilung: **22.10.2003**
(21) Anmeldenummer: 00963915.4
(22) Anmeldetag: 22.08.2000
(51) Int. Cl.: H05K 13/08, H05K 13/02

(54) **VERFAHREN UND SYSTEM ZUM BESTÜCKEN VON IN EINER BESTÜCKUNGSEINHEIT ANGEORDNETEN SCHALTUNGSTRÄGERN**
METHOD AND DEVICE FOR ASSEMBLING CIRCUIT CARRIERS ARRANGED IN A PICK AND PLACE MACHINE
PROCEDE ET SYSTEME DESTINE A EQUIPER DES SUPPORTS DE CIRCUITS DISPOSES DANS UNE UNITE A EQUIPER

(30) Priorität: 26.08.1999 DE 19940584
(43) Veröffentlichungstag der Anmeldung: 22.05.2002
(73) Patentinhaber: SIEMENS AKTIENGESELLSCHAFT, 80333 München (DE)
(72) Erfinder: LAUMANN, Rolf, 33184 Altenbeken (DE)
(86) Internationale Anmeldenummer: DE0002857
(87) Internationale Veröffentlichungsnummer: WO01017328

(56) Entgegenhaltungen:
- JP-A- 2 202 100
- JP-A- 6 006 098
- JP-A- 6 061 685

## Beschreibung

Die Erfindung betrifft ein Verfahren zum Bestücken von in einer Bestückungseinheit angeordneten Schaltungsträgern mit elektronischen Bauteilen, insbesondere SMD-Bauteilen, wobei die bestückungsbezogenen Daten in einer die Bestükkungseinheiten steuernden Leitrechnereinheit abgespeichert werden. Ferner betrifft die Erfindung ein System zum Bestücken von in einer Bestückungseinheit angeordneten Schaltungsträgern mit elektronischen Bauteilen, insbesondere SMD-Bauteilen, mit einer Leitrechnereinheit zur Steuerung der Bestückungseinheiten.

Es ist bekannt, zum Bestücken von Schaltungsträgern eine Bestückungseinheit vorzusehen, die selbsttätig eine Mehrzahl von derselben zugeführten elektronischen Bauteilen nach einer vorgegebenen Vorschrift auf dem Schaltungsträger positioniert und kontaktiert. Üblicherweise werden die elektronischen Bauelemente, die in Form eines Gebindes bereitgehalten werden, kontinuierlich der Bestückungseinheit zugeführt. Eine Leitrechnereinheit ist vorgesehen zur Steuerung der Bestückungseinheit; sie liefert bestückungsbezogenen Daten, mittels derer der Bestückungsvorgang selbsttätig erfolgen kann; siehe z.B. JP-A-02 202 100.

Die Bestückungseinheit weist eine Mehrzahl von Zuführspuren auf, denen jeweils ein vorgegebenes Gebinde zugeordnet wird. Das Zuordnen der Gebinde zu den jeweiligen Zuführspuren erfolgt während des Rüstvorganges manuell, wobei von einer Bedienperson eine Zuführtabelle abgelesen wird. Dabei kann es aufgrund einer Unachtsamkeit der Bedienperson zu einer fehlerhaften Zuordnung des Gebindes zu einer Zuführspur kommen.

Aufgabe der vorliegenden Erfindung ist es daher, ein Verfahren und ein System zum Bestücken von in einer Bestükkungseinheit angeordneten Schaltungsträgern anzugeben, daß eine sichere und zuverlässige Zuordnung des Gebindes zu einer vorgegebenen Zuführspur der Bestückungseinheit gewährleistet ist.

Zur Lösung dieser Aufgabe ist das erfindungsgemäße Verfahren dadurch gekennzeichnet, daß aus den bestückungsbezogenen Daten rüstbezogene Daten extrahiert und zu einem tragbaren Rüstkontrollträger übertragen werden, der vor dem Beginn des Bestückungsvorgangs mit einer jeweils der Bestückungseinheit zugeordneten Zuführkontrolleinheit gekoppelt wird, so daß die elektronischen Bauteile nur dann der Bestückungseinheit zugeführt werden, wenn sie einer durch die rüstbezogenen Daten gekennzeichneten Zuführspur der Bestückungseinheit zugeordnet sind.

Zur Lösung dieser Aufgabe ist das erfindungsgemäße System dadurch gekennzeichnet, daß jeweils im Bereich der Zuführung der Bestückungseinheit eine Zuführkontrolleinheit vorgesehen ist mit einer Steuereinheit und einer Mehrzahl von Lesegeräten zum Lesen von auf einem Identifikationsträger abgespeicherten bauteilebezogenen Daten einerseits. und zum Lesen von auf einem tragbaren Rüstkontrollträger abgespeicherten rüstbezogenen Daten andererseits und daß Mittel vorgesehen sind, derart, daß aus in elektronischer Form in der Leitrechnereinheit vorliegenden bestückungsbezogenen Daten rüstbezogene Daten ableitbar sind, die in den Rüstkontrollträger eingeschrieben werden.

Der besondere Vorteil des erfindungsgemäßen Verfahrens besteht darin, daß durch das Extrahieren von rüstbezogenen Daten aus den vorhandenen bestückungsbezogenen Daten auf einfache Weise Kontrolldaten generiert werden können, mittels derer zuverlässig und sicher die Zuordnung von während eines Rüstvorgangs den jeweiligen Zuführspuren der Bestückungseinheit zuordnenden Gebinden überprüft werden kann. Die rüstbezogenen Daten liegen in elektronischer Form einer Zuführkontrolleinheit vor, in der die Überprüfung einer korrekten Zuordnung der Gebinde zu den Zuführspuren erfolgt.

Nach einer Weiterbildung des erfindungsgemäßen Verfahrens wird in der Zuführkontrolleinheit ein Freigabesignal erzeugt, sofern eine korrekte Zuordnung der Gebinde zu den Zuführspuren gegeben ist. Erst nach Abgabe des Freigabesignals kann eine Bestückung erfolgen. Somit kann erst nach Überprüfung aller einer Bestückungseinheit zugeordneten Gebinden der Bestückungsvorgang in Gang gesetzt werden. Eine fehlerhafte Bestückung des Schaltungsträgers kann somit sicher vermieden werden.

Nach einer Weiterbildung des erfindungsgemäßen Verfahrens wird das Freigabesignal nur dann erzeugt, wenn eine elektrische Verbindung zwischen einem eine bestimmte Zuordnung von Gebinden charakterisierenden Rüstkontrollträger und der Zuführkontrolleinheit besteht. Vorteilhaft sind die rüstbezogenen Daten ausschließlich auf dem Rüstkontrollträger abgespeichert, so daß ausschließlich die aktuellen rüstbezogenen Daten zur Kontrolle der Zuordnung herangezogen werden können. Die Zugrundelegung von falschen, aus vorherigen Rüstvorgängen benutzten rüstbezogenen Daten kann somit sicher vermieden werden.

Der Vorteil des erfindungsgemäßen System besteht insbesondere darin, daß eine sichere und zuverlässige Überprüfung der Zuordnung der Gebinde zu vorgegebenen Zuführspuren der Bestückungseinheit erzielt wird. Grundgedanke der Erfindung ist es, die das Gebinde charakterisierenden bauteilebezogenen Daten in einem vorzugsweise fest mit dem Gebinde verbundenen Identifikationsträger einerseits und die die vorgegebene Zuordnung der Gebinde zu den Zuführspuren der Bestückungseinheit kennzeichnenden rüstbezogenen Daten in einem Rüstkontrollträger andererseits abzuspeichern. Durch Vergleich der rüstbezogenen Daten und der bauteilebezogene Daten in einer Zuführkontrolleinheit kann die Zuordnung auf einfache Weise elektronisch überprüft und gegebenenfalls eine Korrektur der Zuordnung signalisiert werden. Vorteilhaft sind die rüstbezogenen Daten aus den einer Leitrechnereinheit zur Verfügung stehenden bestückungsbezogenen Daten ableitbar. Die Zugangskontrolleinheit ist autark und unabhängig von der Leitrechnereinheit betreibbar. Sie ist vorzugsweise in unmittelbarer Nähe zu der Bestückungseinheit angeordnet.

Dadurch, daß der Rüstkontrollträger tragbar ausgebildet ist, können die rüstbezogenen Daten nach dem Abspeichern derselben einfach handhabbar der Zugangskontrolleinheit zugeführt werden. Hierdurch ist das System flexibel ausgestaltet. Eine Datenverbindung zwischen der Leitrechnereinheit und der Zugangskontrolleinheit ist nicht notwendig.

Nach einer besonderen Ausführungsform des erfindungsgemäßen Systems ist die Leitrechnereinheit direkt mit einem Schreib-/Lesegerät verbunden, so daß nach dem Generieren der rüstbezogenen Daten dieselben direkt auf den tragbaren Rüstkontrollträger abgespeichert werden können. Hierdurch wird eine schnelle und einfache Bereitstellung der rüstbezogenen Daten auf dem Rüstkontrollträger ermöglicht.

Nach einer alternativen Ausführungsform ist die Leitrechnereinheit über eine Datenleitung mit einer gesonderten Rechnereinheit verbunden, zu der die rüstbezogenen Daten übertragen werden. Diese Rechnereinheit kann ein handelsüblicher Personalcomputer sein, der mit einem Schreib-/Lesegerät ausgestattet ist. Hierdurch kann ein vorhandenes Datennetz ausgenutzt werden, um an einem beliebigen Ort den Rüstkontrollträger mit den rüstbezogenen Daten zu beschreiben.

Nach einer Weiterbildung der Erfindung kann eine Bauteile-Rechnereinheit vorgesehen sein, die eine Bauteile-Datenbank aufweist. Hierdurch wird ermöglicht, daß nicht nur die eigentliche Bauteilekennung der auf den jeweiligen Gebinde angeordneten elektronischen Bauteile elektronisch auf dem Identifikationsträger abgespeichert wird, sondern daß weitere, die Bauteile charakterisierende Informationen zusätzlich auf dem Identifikationsträger abgespeichert werden. Somit enthält der Identifikationsträger bauteilebezogene Daten, die es einer Bedienperson jederzeit - mittels eines tragbaren Lesegerätes - ermöglichen, die auf dem Gebinde zusammengefaßten Bauteile zu identifizieren.

Nach einer Weiterbildung der Erfindung sind der Identifikationsträger und/oder der Rüstkontrollträger als chipkarte ausgebildet, die einen elektronischen Speicher aufweisen. Vorteilhaft können die entsprechenden Daten einfach aus handelsüblichen Schreib-/Lesegeräten eingeschrieben bzw. herausgelesen werden.

Ein Ausführungsbeispiel der Erfindung wird nachfolgend anhand der Zeichnungen näher erläutert.

Es zeigen:
- Figur 1: ein Blockschaltbild eines erfindungsgemäßen Systems,
- Figur 2: ein Ablaufdiagramm zum Generieren der rüstbezogenen Daten, die auf einem Rüstkontrollträger abgespeichert werden und
- Figur 3: ein Ablaufdiagramm zur Generierung von bauteilebezogenen Daten.

Das erfindungsgemäße System besteht im wesentlichen aus einer Mehrzahl von hintereinander in einer Produktionslinie angeordneten Bestückungseinheiten 1, denen jeweils an gegenüberliegenden Seiten über eine Mehrzahl von Zuführspuren 2 eine Vielzahl von elektronischen Bauteilen zugeführt werden. Die zugeführten elektronischen Bauteile sind vorzugsweise SMD-Bauteile, die in der Bestückungseinheit 1 auf einem nicht dargestellten Schaltungsträger positioniert und kontaktiert werden. Zur Steuerung dieses Bestükkungsvorganges ist eine Leitrechnereinheit 3 vorgesehen, die einer Mehrzahl von Bestückungseinheiten zugeordnet ist, und den Bestückungsablauf vorgibt, nach dem die einzelnen Bestückungseinheiten 1 selbsttätig die Bestückung vornehmen.

Der jeweils an einer Seite der Bestückungseinheit 1 angeordneten Reihe von Zuführspuren 2 ist jeweils eine Zuführkontrolleinheit 4 zugeordnet, die eine nicht dargestellte vorzugsweise als Mikrokontroller ausgebildete Steuereinheit und eine Mehrzahl von Kartenlesegeräten 5 mit Einführschlitzen 6 zum Einstecken von Chipkarten 7 aufweist. Die Steuereinheit der Zuführkontrolleinheit 4 ist jeweils mit den Kartenlesegeräten 5 elektrisch verbunden. Die Chipkarten 7 weisen jeweils einen elektronischen Speicher, vorzugsweise EEPROM-Speicher, auf. Alternativ kann die Chipkarte auch als Mikroprozessorkarte ausgebildet sein.

Der Zuführkontrolleinheit 4 sind jeweils eine einzige Chipkarte 7 als Rüstkontrollträger 8 und eine zu der Anzahl der Zuführspuren 2 korrespondierende Anzahl von Chipkarten 7 als Identifikationsträger 9 zugeordnet. Der Rüstkontrollträger 8 weist die rüstbezogenen Daten auf, die für den Rüstvorgang erforderlich sind. Die rüstbezogenen Daten bestehen aus der Information über die jeweilige Rüstung, die Produktionslinie, die Kennzeichnung der Bestückungseinheit 1, die Seite der Bestückungseinheit 1, an denen die Bauteile zugeführte werden sollen, sowie die Belegung der einzelnen Zuführspuren 2 durch Zuweisung der entsprechenden Zuführspur 2 mit einer Bauteilekennung.

Der Identifikationsträger 9 weist als notwendige Information die Bauteilekennung sowie weitere die auf dem Gebinde befindlichen die Bauteile kennzeichnenden Informationen auf. Diese bauteilebezogenen Daten werden nach dem Einsetzen der Identifikationsträger 9 in die jeweiligen Kartenlesegeräte 5 herausgelesen und in der Steuereinheit der Zuführkontrolleinheit 4 mit den vorgegebenen rüstbezogenen Daten, die von dem aus einem räumlich abgetrennten Kartenlesegerät 5 aus den Rüstkontrollträgern 8 entnommen auf Übereinstimmung überprüft. Stimmt die durch den Rüstkontrollträger 8 vorgegebene Belegung der Zuführspuren 2 mit den entsprechenden, den jeweiligen Zuführspuren 2 zugeordneten bauteilebezogene Daten überein, ist die Zuordnung der Gebinde, die vorzugsweise mit dem jeweiligen Identifikationsträger 9 fest und lösbar verbunden ist, korrekt. Durch Abgabe eines Freigabesignals kann der Bestückungsvorgang nun in Gang gesetzt werden. Auf diese Weise wird sicher eine falsche Belegung der Zuführspuren 2 mit Gebinden vermieden.

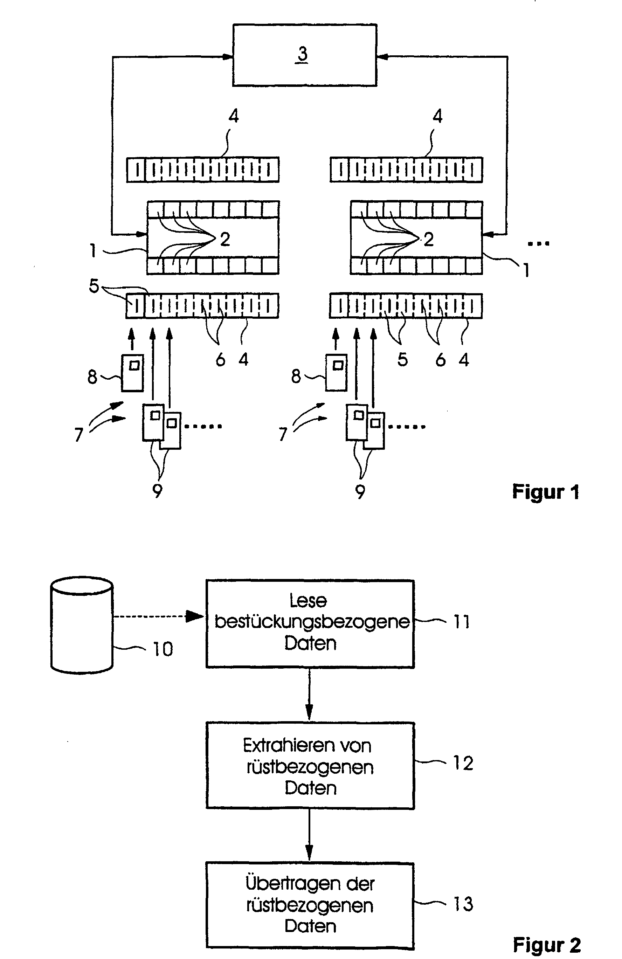

Die Generierung der rüstbezogenen Daten erfolgt in der gemäß Figur 2 dargestellten Weise. Aus einer Datenbank 10 der Leitrechnereinheit 3 werden bestückungsbezogene Daten, die alle für den Bestückungsvorgang relevanten Steuerdaten umfaßt, in einem Schritt 11 herausgelesen. In einem darauffolgenden Schritt 12 werden die rüstbezogenen Daten aus den bestückungsbezogenen Daten extrahiert und nachfolgend in einem Schritt 13 mittels eines nicht dargestellten Schreib-/Lesegerätes an den Rüstkontrollträger 8 übertragen. Dieser Ablauf kann nach einer ersten Ausführungsform in der als UNIX-Rechnerarchitektur ausgebildeten Leitrechnereinheit 3 integriert ablaufen. Nach einem zweiten Ausführungsbeispiel kann der Ablauf auch in einem nicht dargestellten handelsüblichen Personalcomputer erfolgen, der örtlich getrennt von der Leitrechnereinheit 3, aber mittels einer Datenverbindung mit derselben verbunden ist.

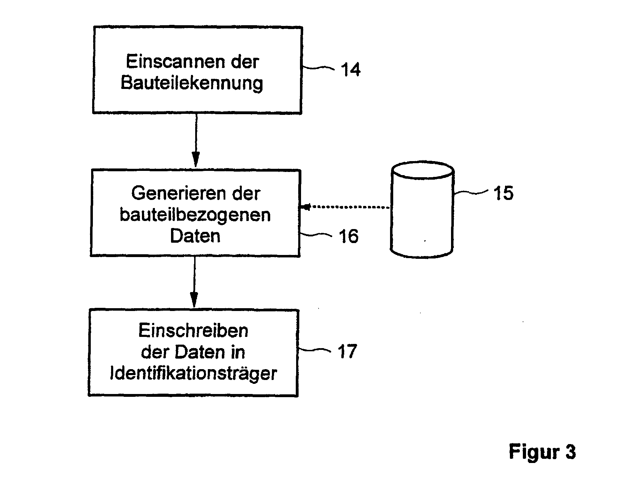

Zur Generierung der bauteilebezogenen Daten in den Identifikationsträgern 9 ist nach einem Ausführungsbeispiel gemäß Figur 3 vorgesehen, daß die auf dem Gebinde als Strichcode vorhandene Bauteilekennung mittels eines Handscanners in einem nicht dargestellten Personalcomputer eingelesen wird, Schritt 14. Durch Abrufen erweiterter bauteilebezogener Daten wie beispielsweise die Bezeichnung des Bauteils, die Bauform etc. aus einer Datenbank 15 können erweiterte bauteilebezogene Daten generiert werden, siehe Schritt 16. Diese bauteilebezogenen Daten können dann mittels eines Schreib-/Lesegerätes in den Identifikationsträger 9 geschrieben werden, Schritt 17. Der Identifikationsträger 9 enthält nunmehr Informationen, die den Inhalt bzw. den Zustand des jeweiligen Gebindes kennzeichnen. Diese Informationen sind auf einfache Weise mittels eines mobilen Handlesegerätes jederzeit abrufbar.

Beispielsweise kann es vorgesehen sein, in dem Identifikationsträger 9 Angaben über die Anzahl der auf dem Gebinde angeordneten Bauteile zu speichern. Somit ist nach einem mehrmaligen Gebrauch des Gebindes jederzeit die aktuelle Anzahl der Bauteile auf dem Gebinde visualisierbar. Voraussetzung dafür ist, daß nach dem Bestückungsvorgang die Anzahl der verbrauchten Bauteile in den entsprechenden Identifikationsträger 9 eingeschrieben wird.

## Patentansprüche

1. Verfahren zum Bestücken von in einer Bestückungseinheit angeordneten Schaltungsträgern mit elektronischen Bauteilen, insbesondere SMD-Bauteilen, wobei die bestückungsbezogenen Daten in einer die Bestückungseinheiten steuernden Leitrechnereinheit abgespeichert werden, **dadurch gekennzeichnet, daß** aus den bestückungsbezogenen Daten rüstbezogene Daten extrahiert und zu einem tragbaren Rüstkontrollträger (8) übertragen werden, der vor dem Beginn des Bestückungsvorgangs mit einer jeweils der Bestückungseinheit (1) zugeordneten Zuführkontrolleinheit (4) gekoppelt wird, so daß die elektronischen Bauteile nur dann der Bestückungseinheit (1) zugeführt werden, wenn sie einer durch die rüstbezogenen Daten gekennzeichneten Zuführspur (2) der Bestückungseinheit (1) zugeordnet sind.

2. Verfahren nach Anspruch 1, **dadurch gekennzeichnet, daß** in der Zuführkontrolleinheit (4) ein Freigabesignal zur Freigabe der Zuführspur (2) für die in einem Gebinde bereitgehaltenen Bauteile erzeugt wird, sofern die Zuordnung des entsprechenden Gebindes zu der durch die rüstbezogenen Daten vorgegebenen Zuführspur (2) gegeben ist.

3. Verfahren nach Anspruch 1 oder 2, **dadurch gekennzeichnet, daß** das Freigabesignal nur dann erzeugt wird, wenn eine elektrische Verbindung zwischen dem Rüstkontrollträger (8) und der Zuführkontrolleinheit (4) besteht.

4. System zum Bestücken von in einer Bestückungseinheit angeordneten Schaltungsträgern mit elektronischen Bauteilen, insbesondere SMD-Bauteilen, mit einer Leitrechnereinheit zur Steuerung der Bestückungseinheiten, **dadurch gekennzeichnet, daß** jeweils im Bereich der Zuführung der Bestückungseinheit (1) eine Zuführkontrolleinheit (4) vorgesehen ist mit einer Steuereinheit und einer Mehrzahl von Lesegeräten (5) zum Lesen von auf einem Identifikationsträger (9) abgespeicherten bauteilebezogenen Daten einerseits und zum Lesen von auf einem tragbaren Rüstkontrollträger (8) abgespeicherten rüstbezogenen Daten andererseits und daß Mittel vorgesehen sind, derart, daß aus in elektronischer Form in der Leitrechnereinheit (3) vorliegenden bestückungsbezogenen Daten rüstbezogene Daten ableitbar sind, die in den Rüstkontrollträger (8) eingeschrieben werden.

5. System nach Anspruch 4, **dadurch gekennzeichnet, daß** die Leitrechnereinheit (3) mit einem Schreib-/Lesegerät verbunden ist, derart, daß die rüstbezogenen Daten direkt auf den Rüstkontrollträger (8) einschreibbar sind.

6. System nach Anspruch 4, **dadurch gekennzeichnet, daß** die Leitrechnereinheit (3) mit einer gesonderten Rechnereinheit über eine Datenleitung verbunden ist, mittels derer die rüstbezogenen Daten zu der Rechnereinheit übertragbar sind, und daß die Rechnereinheit mit einem Schreib-/Lesegerät verbunden ist zum Beschreiben des Rüstkontrollträgers (8) mit den rüstbezogenen Daten.

7. System nach einem der Ansprüche 4 bis 6, **dadurch gekennzeichnet, daß** die bestückungsbezogenen Daten mindestens in einer Datenbank (10) der Leitrechnereinheit (3) abgespeichert sind.

8. System nach einem der Ansprüche 4 bis 7, **dadurch gekennzeichnet, daß** eine Datenbank (15) zur Speicherung von die Bauteile kennzeichnenden Informationen vorgesehen ist, aus der die einem jeweiligen Gebinde zugeordneten bauteilebezogenen Daten generierbar sind, und daß die betreffenden bauteilebezogenen Daten auf den dem korrespondierenden Gebinde zugeordneten Identifikationsträger (9) beschreibbar sind.

9. System nach einem der Ansprüche 4 bis 8, **dadurch gekennzeichnet, daß** eine Bauteilekennung als Strichcode auf dem Gebinde aufgebracht ist und nach Lesen mittels eines Strichcodelesers mit den in der Datenbank (15) vorhandenen bauteilebezogenen Daten in der Weise verknüpfbar ist, daß die Bauteilekennung selbsttätig um die weiteren rüstbezogenen Daten erweitert wird.

10. System nach einem der Ansprüche 4 bis 9, **dadurch gekennzeichnet, daß** der Rüstkontrollträger (8) und/oder der Identifikationsträger (9) als Chipkarte (7) ausgebildet sind.

## Claims

1. Method for assembling circuit boards arranged in an assembly unit with electronic components, in particular SMD components, with the assembly-related data being stored in a host computer unit controlling the assembly units, **characterised in that** setup-related data is extracted from the assembly-related data and transferred to a portable setup control medium (8), which is linked before the start of the assembly process to a feed control unit (4) assigned in each case to the assembly unit (1) so that the electronic components are only fed to the assembly unit (1) when they have been assigned to a feed track (2) of the assembly unit (1) **characterised by** the setup-related data.

2. Method according to Claim 1, **characterised in that** a release signal is generated in the feed control unit (4) to release the feed track (2) for the components supplied in a package, in so far as the corresponding package has been assigned to the feed track (2) predetermined by the setup-related data.

3. Method according to Claim 1 or 2, **characterised in that** the release signal is only generated when there is an electrical connection between the setup control medium (8) and the feed control unit (4).

4. System for assembling circuit boards arranged in an assembly unit with electronic components, in particular SMD components, with a host computer unit to control the assembly units, **characterised in that** a feed control unit (4) is provided near to each feed of the assembly unit (1) with a control unit and a plurality of readers (5) for reading component-related data stored on an identification medium (9) on the one hand and for reading setup-related data stored on a portable setup control medium (8) on the other hand and that means are provided so that setup-related data can be derived from assembly-related data available in electronic form in the host computer unit (3) and written into the setup control medium (8).

5. System according to Claim 4, **characterised in that** the host computer unit (3) is connected to a read/write device in such a way that setup-related data can be written directly onto the setup control medium (8).

6. System according to Claim 4, **characterised in that** the host computer unit (3) is connected to a separate computer unit via a data line, by means of which the setup-related data can be transferred to the computer unit, and that the computer unit is connected to a read/write device for writing setup-related data onto the setup control medium (8).

7. System according to one of Claims 4 to 6, **characterised in that** the assembly-related data at least is stored in a database (10) of the host computer unit (3).

8. System according to one of Claims 4 to 7, **characterised in that** a database (15) is provided for storing information **characterising** the components, from which the component-related data assigned to a respective package can be generated, and that the relevant component-related data can be written onto the identification medium (9) assigned to the corresponding package.

9. System according to one of Claims 4 to 8, **characterised in that** a component identifier is marked on the package in the form of a bar code and can be linked to the component-related data in the database (15) after reading with a bar code reader in such a manner that the component identifier is automatically extended to include the additional setup-related data.

10. System according to one of Claims 4 to 9, **characterised in that** the setup control medium (8) and/or the identification medium (9) are configured as chip cards (7).

## Revendications

1. Procédé destiné à équiper des supports de circuits, disposés dans une unité à planter les composants, avec des composants électroniques, en particulier des composants à montage en surface (ou, en anglais, composants SMD), les données relatives à l'équipement étant mémorisées dans une unité ordinateur de commande, qui contrôle les unités à planter les composants, **caractérisé par le fait que** des données relatives au chargement sont extraites des données relatives à l'équipement et transmises à un support portable (8) de contrôle du chargement, qui est couplé, avant le début du processus de montage des composants, à une unité (4) de contrôle de l'alimentation affectée à chaque unité (1) à planter les composants, si bien que les composants électroniques ne sont envoyés à l'unité (1) à planter les composants que s'ils sont affectés à une piste (2) d'alimentation de l'unité (1) à planter les composants **caractérisée par** les données relatives au chargement.

2. Procédé selon la revendication 1 **caractérisé par le fait que**, dans l'unité (4) de contrôle de l'alimentation, un signal de validation, destiné à valider la piste (2) d'alimentation pour les composants tenus à disposition dans une liasse, est généré dans la mesure où il existe une concordance entre la liasse correspondante et la piste (2) d'alimentation données par les données relatives au chargement.

3. Procédé selon la revendication 1 ou 2 **caractérisé par le fait que** le signal de validation n'est généré que s'il existe une liaison électrique entre le support (8) de contrôle du chargement et l'unité de contrôle de l'alimentation (4).

4. Système destiné à équiper des supports de circuits, disposés dans une unité à planter les composants, avec des composants électroniques, en particulier des composants à montage en surface (ou, en anglais, composants SMD), et comportant une unité ordinateur de commande destinée à la commande des unités à planter les composants, **caractérisé par le fait que**, dans chaque cas, il est prévu, dans la zone d'alimentation de l'unité (1) à planter les composants, une unité (4) de contrôle de l'alimentation comportant une unité de commande et une pluralité de lecteurs (5) destinés à lire des données relatives aux composants mémorisées sur un support (9) d'identification, d'une part, et à lire des données relatives au chargement mémorisées sur un support (8) portable de contrôle du chargement, d'autre part, et qu'il est prévu des moyens tels que, à partir des données relatives à l'équipement disponibles sous forme électronique dans l'unité (3) ordinateur de commande, il est possible de déduire des données relatives au chargement qui sont inscrites sur le support (8) de contrôle du chargement.

5. Système selon la revendication 4 **caractérisé par le fait que** l'unité (3) ordinateur de commande est reliée à un appareil d'écriture et lecture de telle sorte que les données relatives au chargement peuvent être écrites directement sur le support (8) de contrôle du chargement.

6. Système selon la revendication 4 **caractérisé par le fait que** l'unité (3) ordinateur de commande est reliée à une unité ordinateur spéciale, par l'intermédiaire d'une ligne de données, au moyen de laquelle les données relatives au chargement peuvent être transmises à l'unité ordinateur, et que l'unité ordinateur est reliée à un appareil d'écriture et lecture destiné à inscrire les données relatives au chargement sur le support (8) de contrôle du chargement.

7. Système selon l'une des revendications 4 à 6 **caractérisé par le fait que** les données relatives à l'équipement sont mémorisées au moins dans une banque de données (10) de l'unité (3) ordinateur de commande.

8. Système selon l'une des revendications 4 à 7 **caractérisé par le fait qu'**il est prévu une banque de données (15) destinée au stockage d'informations caractérisant les composants et à partir de laquelle il est possible de générer les données relatives aux composants affectées aux liasses respectives, et que les données concernées relatives aux composants peuvent être écrites sur le support (9) d'identification affecté à la liasse correspondante.

9. Système selon l'une des revendications 4 à 8 **caractérisé par le fait qu'**un indicatif des composants est apportée, sous la forme de code à barres, sur la liasse et que cet indicatif peut, après avoir été lu au moyen d'un lecteur de code à barres, être combiné aux données relatives aux composants disponibles dans la banque de données (15) de telle manière que l'indicatif des composants est automatiquement complétée par d'autres données relatives au chargement.

10. Système selon l'une des revendications 4 à 9 **caractérisé par le fait que** le support (8) de contrôle du chargement et/ou le support (9) d'identification sont conçus comme cartes à puces (7).
